# EUROPÄISCHE PATENTSCHRIFT

(11) **EP 2 345 091 B1**
(45) Veröffentlichungstag und Bekanntmachung des Hinweises auf die Patenterteilung: **16.12.2015**
(21) Anmeldenummer: 09777656.1
(22) Anmeldetag: 05.08.2009
(51) Int. Cl.: H01L 31/20, H01L 31/18, H01L 31/0392

(54) **RANDENTSCHICHTUNG VON DÜNNSCHICHTSOLARMODULEN MITTELS ÄTZEN**
EDGE DELETION OF THIN-LAYER SOLAR MODULES BY MEANS OF ETCHING
DÉCAPAGE DES BORDS DE MODULES SOLAIRES EN COUCHES MINCES

(30) Priorität: 01.09.2008 EP 08015378
(43) Veröffentlichungstag der Anmeldung: 20.07.2011
(73) Patentinhaber: Merck Patent GmbH, 64293 Darmstadt (DE)
(72) Erfinder: DOLL, Oliver, 63128 Dietzenbach (DE); KOEHLER, Ingo, 64354 Reinheim (DE)
(86) Internationale Anmeldenummer: PCT/EP2009/005653
(87) Internationale Veröffentlichungsnummer: WO 2010/022849

(56) Entgegenhaltungen:
- EP-A1- 1 039 554
- EP-A1- 2 068 370
- DE-A1-102005 007 743
- DE-A1-102006 051 952
- US-B1- 6 384 315

## Beschreibung

Die vorliegende Erfindung betrifft ein schnelles und kostengünstiges lokal durchführbares Verfahren zur nasschemischen Randentschichtung von Solarmodulen/-zellen, indem für diesen Zweck geeignete Ätzpasten aufgetragen und nach erfolgter Reaktion die Pastenreste entfernt werden bzw. die Substratoberfläche in geeigneter Weise gereinigt wird. In dem Verfahren wird eine für den Zweck neu entwickelte Ätzpaste eingesetzt.

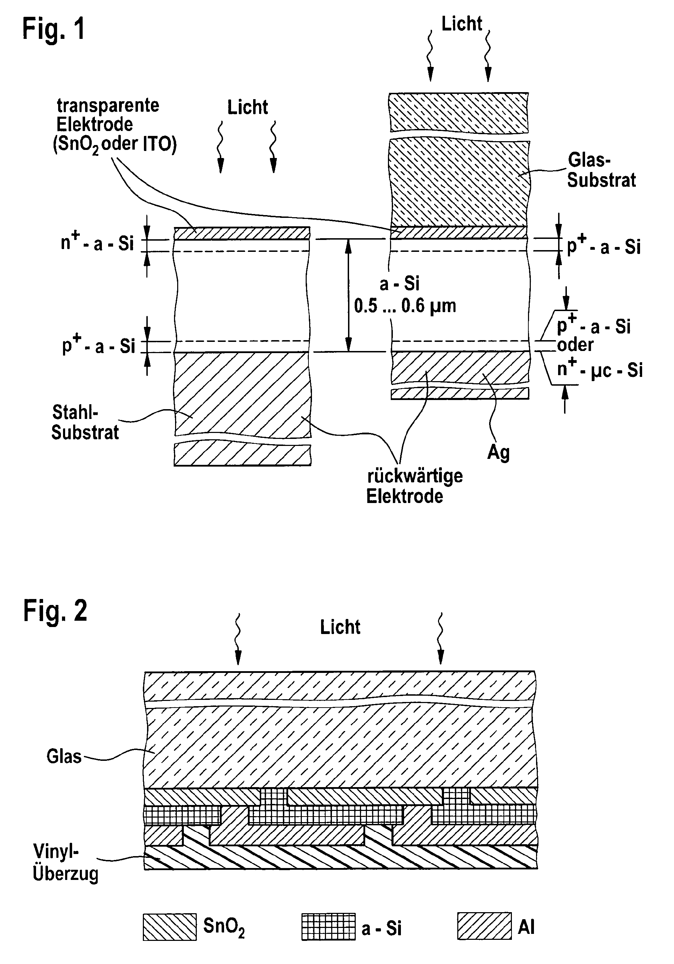

Die industrielle Produktion von Dünnschichtsolarmodulen/-zellen erfolgt derzeit auf größtenteils inerten (großflächige Stahlbleche bilden hierunter eine Ausnahme) großflächigen Trägermaterialien, welche u. a. Glasscheiben, Kunststofffolien oder -scheiben und/oder Stahlplatten sein können. Nach und während der ganzflächigen Deponierung funktioneller dünner Schichten auf den inerten Trägermaterialien, die das spätere Solarmodul/-zelle definieren, werden die funktionellen aktiven Schichten der Solarmodule zweckmäßig in einzelne Solarzellen unterteilt, wobei das Trägermaterial ganzflächig erhalten bleibt. Im folgenden Kontext wird der Begriff "Solarmodul" synonym für ein Dünnschicht-Solarmodul als auch für eine Anordnung mehrerer elektrisch verschalteter Dünnschicht-Solarzellen verwendet - sprich in der Allgemeinheit als Oberbegriff verwendet für alle photovoltaischen Bauteile, die im Allgemeinen unter dem Begriff "Dünnschicht-Photovoltaik" vom Fachmann verstanden werden. Ein typisches "Solarmodul" ist aus einem Stapel dünner funktionaler Schichten aufgebaut, die, vom Substrat aus gesehen, folgende Untergliederung aufweisen (siehe Abbildung 1):
a) (transparente) Elektrode,
b) gegensätzlich dotierte und ggfs. undotierte Halbleiterschichten sowie abschließend, sogenannte pin- als auch nip-Strukturen
c) eine weitere Elektrode.

In Abbildung 1 ist ein entsprechender schematischer Aufbau von Solarmodulen wie beschrieben wieder gegeben.

In Abbildung 2 ist schematisch eine Verkapselung von Solarmodulen gezeigt, wie sie durch Hans-Günther Wagemann und Heinz Eschrich, in: Photovoltaik, 1. Aufl., 2007, B. G. Teubner Verlag, Wiesbaden, Germany beschrieben und dargestellt ist.

Abweichungen von diesem allgemein in den Abbildungen 1 und 2 skizzierten Aufbau sind jeweils möglich.

Nach der Strukturierung des "Solarmoduls" ist es notwendig, die nicht durch das Trägermaterial begrenzte Oberfläche (d. h. die Oberfläche, die durch die Deposition der dünnen funktionellen Schichten gekennzeichnet ist) zu versiegeln und einzukapseln, um es somit vor leichten mechanischen Beschädigungen als auch vor der chemisch-physikalischen Materialerosion infolge von Witterungseinflüssen zu schützen (vgl. Abbildung 2). Üblicherweise wird zu diesem Zweck die zu versiegelnde Oberfläche mit einer äußerst beständigen Polymerbeschichtung, Kunststofffolie oder einer deckungsgleichen Glasscheibe bzw. einer Abfolge aus mehrerer eben erwähnter Elemente bedeckt. Der Verbund der Oberflächenversiegelung mit dem Trägermaterial erfolgt am Rand des Solarmoduls mittels Verklebens mit Hilfe von Mehrkomponentenklebstoffen und/oder mittels Laminierens unter Anwendung eines hierfür geeigneten Polymers. Hierfür muss der Rand des Trägermaterials für etwa einen bis zwei Zentimeter von dem deponierten funktionalen Schichtenstapel befreit werden, um somit die Haftung des Laminatverbunds auf dem Trägermaterial zu gewährleisten und gleichzeitig das "Solarmodul" vor chemisch-physikalischen Einflüsse zu schützen, die über diese Randstelle auf das gesamte "Solarmodul" einwirken können. Im weiteren Zusammenhang ist unter dem Begriff "Substrat" das System zu verstehen, auf welchem die Ätzpasten appliziert werden. Die Entfernung des funktionalen Schichtenstapel im einen bis zwei Centimeter breiten Randbereich des Trägermaterials wird im folgenden Text als "Randentschichtung" bezeichnet.

Derzeit wird die Randentschichtung industriell mittels Sandstrahlen, Schleifen des Randbereiches mit einer rotierenden Schleifscheibe und/oder Lasersystemen durchgeführt.

In US 6,384,315 B1 wird die erforderliche Randentschichtung entweder durch mechanische Verfahren oder mittels Laserbestrahlung durchgeführt. Mechanisch erfolgt die Randentschichtung in diesem Fall mittels eines Oberflächenschleifverfahrens oder eines mechanischen Ätzverfahrens unter Verwendung eines feinen Teilchenstrahls. Beide Verfahren erfordern jedoch einen hohen apparativen Aufwand, um die erforderliche Präzision zu gewährleisten. Weiterhin führt die Behandlung mit Laserbestrahlung gegebenenfalls zu unerwünschten Diffusionsvorgängen.

In DE 10 2005 007 743 A1 wird ein druckbares Ätzmediums mit nicht-Newtonschen Fließverhalten in Form einer Ätzpaste zum Ätzen von anorganischen, glasartigen oder kristallinen Oberflächen aus Siliziumoxid oder Siliziumnitrid beschrieben, welches organische Polymerpartikel enthält in Gegenwart von einer ätzenden Komponente, Lösungsmittel, Verdickungsmittel, gegebenenfalls mindestens einer anorganischen und/oder organischen Säure, sowie gegebenenfalls von Additiven. Die enthaltenen Polymerpartikel dienen in diesem Fall als Verdicker und beeinflussen die Druckbarkeit der Paste positiv. Diese Pasten sind sowohl zum Ätzen als auch zum dotieren von Oberflächen unter geeigneten Bedingungen einsetzbar. Als Ätz- und Dotierkomponenten können diese Ätzmedien die verschiedenen Formen der Phosphorsäure oder geeignete Phosphorsäuresalze oder -verbindungen, welche beim Erhitzen zu der entsprechenden Phosphorsäure zersetzt werden, als Ätz- und als Dotierkomponenten enthalten. Diese Zusammensetzungen haben sich jedoch als nicht geeignet erwiesen für die oben beschriebenen Randentschichtungen.

Alle Verfahren weisen als inhärente Nachteile zum einen die großflächige Kontamination der gesamten Moduloberfläche durch partikuläre Verunreinigungen, infolge des Sandstrahles als auch das Zurückbleiben von partiellen Rückstände des Schichtenstapels, und zum anderen Versinterungserscheinungen in angrenzenden Bereichen des entfernten Randes auf. Die Lasertechnologie ist darüber hinaus durch hohe Investitionskosten gekennzeichnet.

### Aufgabenstellung

Aufgabe der vorliegenden Erfindung ist es somit, ein einfaches und kostengünstiges Verfahren zur Verfügung zu stellen, wodurch die oben beschriebenen Nachteile vermieden werden. Weiterhin besteht die vorliegende Aufgabe darin, die für die Durchführung des Verfahrens notwendige Mittel zur Verfügung zu stellen.

### Beschreibung der Erfindung

Es wurde nun gefunden, dass das vorliegende Problem in einfacher Weise gelöst werden kann durch ein schnell und kostengünstig durchführbares Verfahren zur nasschemischen Randentschichtung von "Solarmodulen", indem für diesen Zweck geeignete Ätzpasten aufgetragen und nach erfolgter Reaktion die Pastenreste entfernt werden bzw. die Substratoberfläche in geeigneter Weise gereinigt wird. Dementsprechend ist ebenfalls die in dem Verfahren einsetzbare neue Paste Gegenstand der vorliegenden Erfindung.

Gegenstand der vorliegenden Erfindung ist weiterhin eine Ätzpaste, die sowohl zur Strukturierung von Silicium- als auch von Metallschichten in (mikro-)elektronischen, photovoltaischen und mikroelektromechanischen (MEMS) Bauteilen einsetzbar ist. Unter photovoltaischen Bauteilen sind in diesem Zusammenhang insbesondere und bevorzugt Dünnschichtsolarmodule/-zellen sowie kristalline Solarzellen im Allgemeinen zu verstehen. Erfindungsgemäß sind in diesem Zusammenhang darunter auch zu strukturierende dünne Schichten zu verstehen, die zur Herstellung solcher Bauteile, vorzugsweise von "Solarmodulen", bearbeitet werden müssen.

Beispielhaft, jedoch nicht umfassend, seien hier erwähnt: rückseitenkontaktierte kristalline Solarzellen mit und ohne interdigitierende Kontaktstrukturen, MWT-, EWT-, PERC- PERL und PERT-Solarzellen, Solarzellen mit vergrabenen Kontakten, Kantenisolierungen von Silicumwafern und Solarzellen, Wafer, die durch einseitiges Ätzen und anschließendes Polieren behandelt werden, Trennung und Isolierung von Dünnschicht-Solarzellen aus Dünnschicht-Solarmodulen, Kontaktierungslöcherätzung ("Vias") bei der Herstellung von "Solarmodulen" und -zellen, Strukturierungprozesse während der Herstellung von Anzeige-, Kommunikations- und Leuchtelementen auf Basis der Technologien von Dünnfilmtransistoren (TFT), Flüssigkristallen (LCD), Elektrolumineszenz (EL), organischer lichtemittierender Dioden (OLED) und berührungsempfindlicher kapazitiver und resistiver Sensoren.

Überraschender Weise konnte eine pastöse Ätzmischung entwickelt werden, welche geeignet ist, simultan in einem Schritt funktionelle Schichtenstapel zu ätzen. Anschließend können die anhaftenden Pastenreste in einfacher Weise von der Substratoberfläche entfernt werden und eine Reinigung des Trägermaterials des "Solarmoduls" erfolgen. Auf diese Weise ist es möglich eine Randentschichtung ohne Schädigung der funktionellen dünnen Schichten benachbarter Regionen, die direkt an den mit Paste benetzten Rand angrenzen, durchzuführen. Vorteilhafter Weise ist die erfindungsgemäße Pastenzusammensetzung als solche lagerstabil, so dass die erfindungsgemäße Ätzpaste vom Anwender ohne weitere Vorkehrungen angewendet werden kann.

Folglich ist eine stabilisierte pastösen Ätzmischung in Form einer Ätzpaste Gegenstand der vorliegenden Entwicklung, welche zum simultanen Ätzen des oben erwähnten Stapels funktioneller Schichten einsetzbar ist und wobei die zu ätzenden Schichten aus verschiedenen Materialien, wie z. B. aus dotierten und undotierten Silicium- und Metallschichten und deren Derivaten bestehen können. Entsprechende Metallschichten können aus Al, Ag, Cu, Ni, Cr, Mo, Ta, Ti, W, Zn, TiₓO_{y}, TixWy, NiₓV_{y}, TaₓN_{y}, TiₓN_{y} bestehen. Bei den zu ätzenden Schichten kann es sich auch um Oxide oder Mischoixide, wie Indium-Zinnoxid (ITO), Indium-Zinkoxid (IZO), Indiumoxid (IO), Aluminium-Zinkoxid (AZO), Zinkoxid (ZO) oder ähnliche Oxide handeln. Andererseits können es auch dotierte und undotierte Halbleiterschichten sein, wie c-Si-, a-Si und µ-Si-Schichten, sogenannten pin oder nip-Schichtenstapeln, oder Schichten aus Ge und dessen Legierungen, oder aus GaAs und dessen ternären und quaternären Mischungen oder aus II-IV- als auch II-VI-Halbleiter im Allgemeinen bestehen ^{[2]}.

Während mit Ätzpasten, die üblicherweise in Verfahren zur Herstellung von Solarzellen eingesetzt werden jeweils nur selektiv spezielle Schichten ätzbar sind, ist es mit den erfindungsgemäßen Pasten überraschenderweise möglich, sowohl Metallschichten als auch Halbleiterschichten, die dotiert sein können, aber auch die oben genannten Oxid und Mischoxidschichten in einem Schritt zu ätzen. Daher ist es mit den erfindungsgemäßen Ätzpasten möglich, in vorteilhafter Weise Randschichten von "Solarmodulen" in einem Schritt zu entfernen.

Zur Durchführung des Verfahrens wird die Ätzpaste in einer dem Fachmann bekannten Weise, vorzugsweise mittels Dispensens auf dem Randbereich des "Solarmoduls" zwecks Randentschichtung deponiert. Zur Beschleunigung des Ätzprozesses erfolgt gegebenenfalls eine Aktivierung und Temperung des mit Ätzpaste versehenen Substrates. Durch die erhöhte Temperatur erfolgt eine schnellere Initiierung der Reaktion, aber auch die anschließende (Aus-)Trocknung und Inhibierung des Ätzmediums ist beschleunigt. Bei der Temperung sollte eine Temperatur von maximal 150 °C nicht überschritten werden.

Vorzugsweise wird das Ätzen bei einer Temperatur im Bereich von 30 bis 100 °C durchgeführt, worauf sich eine weitere Temperaturerhöhung anschließen kann, um den Ätzvorgang zu beenden und gegebenenfalls Pastenreste zu entfernen. In einer bevorzugten Durchführungsweise werden im Anschluss an den Ätzschritt die Pastenreste durch Waschen oder Abblasen und Austrocknung bei erhöhter Temperatur im Bereich von 100 bis 145°C entfernt. Es kann sich aber auch direkt an das Ätzen ein Waschschritt anschließen, um Pastenreste zu entfernen.

Weiterhin kann, muss aber nicht notwendigerweise auftreten, eine leichte Ätzung und eine dadurch bedingte Aufrauung des das "Solarmoduls" mechanisch stabilisierenden Trägermaterials erfolgen. Diese kann wünschenswert sein, um im nachfolgenden Herstellungsverfahren eine erhöhte Adhäsion des beschriebenen Laminatverbundes zum Zwecke der Verkapselung zu erzielen.

Die Entfernung der Pastenreste von der Substratoberfläche kann mittels dem Fachmann bekannten und geeigneten Reinigungsverfahren erfolgen, wie beispielsweise durch Abblasen mittels eines Druckluftstrahls, unter Druck stehendem Gasstrahls, Wasserdampfstrahls, oder mit Wasserdampf oder organischen Lösungsmitteln und deren Mischungen gesättigter Druckluft- oder durch einen unter Druck stehenden Gasstrahl, durch einen Lösemitteldampfstrahl, kryogenes Aerosol (z. B. CO₂-Schnee in einem CO₂-Gasstrahl), mittels eines fokussierten Strahles aus Wasser, organischen Lösemitteln und Mischungen organischer Lösemittel mit und ohne Wasser. Alle Reinigungslösungen können für diesen Zweck geeignete Additive, die im Folgenden näher Erwähnung finden, enthalten. Weiterhin kann eine Reinigung der Substratoberflächen erfolgen durch Passieren einer Reinigungsanlage, mit regiospezifischer Pinsel-, Bürsten- und Schwammreinigung, unter der Anwendung von Wasser, organischen Lösemitteln, deren Mischungen, inklusive und exklusive Wasser, sowie gegebenenfalls weitere Additive enthaltend, wie beispielsweise Tenside, Mischungen von Tensiden, Komplex- und Chelatbildner, Schauminhibitoren und funktioneller Salze. Darauffolgend kann eine anschließende Feinspülung unter Anwendung o. g. Spülmedien erfolgen.

Nach diesen Reinigungsschritten wird eine vollständig gereinigte Oberflächenregion erhalten. Sollten noch leichte Pastenverunreinigungen auf der Oberfläche zurückbleiben, wurde gefunden, dass diese ihrerseits die Funktionsweise, das Aufbringen, Aushärten und/oder Laminieren des "Solarmoduls" unter Anwendung obig beschriebener Verkapselungsmaterialien nicht weiter beeinträchtigen.

Gegenstand der vorliegenden Erfindung ist daher eine stabilisierte pastöse Ätzmischung in Form einer Ätzpaste. Diese Paste ist insbesondere zum Ätzen von stapelförmig aufgebauten Silizium- und Metallschichten geeignet und ist daher ganz besonders geeignet zum Randentschichten von "Solarmodulen".

Diese erfindungsgemäßen Ätzpasten können folgende Inhaltstoffe aufweisen:
Wasser, und gegebenenfalls
organische Lösungsmittel und Lösungsmittelgemische,
anorganische und organische Oxidationsmittel,
anorganische und organische Säuren,
polymere anorganische und organische Verdicker,
Gel- und Netzwerkbildner und Füllstoffe,
Thixotropierungsmittel und Rheologiemodifizierer,
gegebenenfalls Komplex- und Chelatbildner,
sowie Maskierungsmittel,
eventuell oberflächenaktive Substanzen, und Verlaufshilfsmittel sowie Tenside,
eventuell Entlüfter und Entschäumer.

Als organische Lösemittel sind bevorzugt DMSO, NMP und ähnliche. Diese Lösungsmittel können allein und als Mischungen eingesetzt werden.

Wie oben erwähnt können die erfindungsgemäßen Ätzpasten Oxidationsmittel enthalten. Bevorzugt werden HNO₃, H₂O₂, NaO₂, KO₂, Na₂S₂O₈, (NH₄)₂S₂O₈, K₂S₂O₈, K₅H₃S₄O₁₈ und anorganische Peroxoverbindungen eingesetzt, wie NaB0_{2*}H₂O₂ und [2 Na₂CO_{3*}3 H₂O₂], HClO₃, NaClO₃, KClO₃, HBrO₃, NaBrO₃, KBrO₃, HIO₃, NaIO₃, KIO₃, KHIO₆, Cr₂O₃, NaCr₂O₇, K₂Cr₂O₇, KMnO₄, NaNO₃, KNO₃, NH₄NO₃, NaClO₄, HClO₄, Selenate (SeO₄²⁻), CH₃CO₃H und organische Peroxoverbindungen, Ce(NO₃)₄, Ce(SO₄)₂, (NH₄)₂Ce(NO₃)₆ und ähnliche sowie deren Mischungen.

Als anorganische und organische Säuren können in den erfindungsgemäßen Pasten bevorzugt Säuren ausgewählt aus der Gruppe HNO₃, H₃PO₄, H₂SO₄, H₂SiF₆, HBF₄, H₂PF₆, H₂PO₃F, H₂PO₂F₂, HF, NH₄H₂F, HCOOH, CH₃COOH und C₂H₅COOH sowie deren Mischungen enthalten sein. Es können aber auch gleichwirkende Säuren enthalten sein.

Darüber hinaus können in den Pasten als Additive Komplex- und Chelatbilder enthalten sein. Bevorzugt werden Chelatbildner ausgewählt aus der Gruppe H₃PO₄, HF, NH₄F, NH₄HF₂, H₂SiF₆, HBF₄, H₂PO₃F, H₂PO₂F₂ und Titriplex I - VIII eingesetzt. Geeignet können aber auch deren phosphonsäurederivatisierten Homologen (Dequest^{®}, Briquest^{®}) und ähnliche sein. Diese Komplex- und Chelatbildner können einzeln oder als Mischungen der Paste zugegeben werden. Besonders bevorzugt werden H₃PO₄, NH₄F, NH₄HF₂ und ähnliche Verbindungen, sowie deren Mischungen, eingesetzt.

Die bevorzugten Komplex- und Chelatbilder werden besonders bevorzugt mit Oxidationsmitteln ausgewählt aus der Gruppe HNO₃, H₂O₂, NaO₂, KO₂, Na₂S₂O₈, (NH₄)₂S₂O₈, K₂S₂O₈, K₅H₃S₄O₁₈ in den erfindungsgemäßen Zusammensetzungen eingesetzt. Aus der Gruppe der Oxidationsmittel wiederum sind HNO₃ und H₂O₂ ganz besonders bevorzugt.

Als besonders wirksam und besonders stabil haben sich Zusammensetzungen erwiesen, welche H₃PO₄, NH₄HF₂ und HNO₃ in Kombination mit weiteren Zusätzen, wie Verdickungsmitteln, Vernetzungsmitteln, Tensiden und anderen Additiven, enthalten. Hier wiederum haben sich Zusammensetzungen als besonders vorteilhaft erwiesen, worin H₃PO₄, NH₄HF₂ und HNO₃ in einem Mischungsverhältnis in einem Bereich von 7 : 1 : 1,5 bis 10 : 1 : 3,5 bezogen auf das Gewicht enthalten sind und wobei sich das Gewicht jeweils auf 85%-ige H₃PO₄ und 65-%ige HNO₃ bezieht. Besonders gute Ätzergebnisse bei gleichzeitiger Stabilität der Zusammensetzung wurden erhalten mit Zusammensetzungen, worin H₃PO₄, NH₄HF₂ und HNO₃ in einem Mischungsverhältnis in einem Bereich von 7,5 : 1 : 1,8 bis 9 : 1 : 3 bezogen auf das Gewicht enthalten sind.

Als besonders stabil haben sich Zusammensetzungen erwiesen, die darüber hinaus Verdickungsmittel, insbesondere Polyvinylpyrrolidon, Polyvinylacetat sowie Polyolefingranulat, enthalten. Als ganz besonders geeignet haben sich Zusammensetzungen erwiesen, die H₃PO₄, NH₄HF₂ und HNO₃ im oben angegebenen Gewichtsverhältnis und Polyvinylpyrrolidon, Polyolefingranulat und aminofunktionalisierter Polyacrylsäure in einer geeigneten Menge enthalten.

Weiterhin können oberflächenaktive Substanzen enthalten sein. Bevorzugt sind dieses solche, ausgewählt aus den Gruppen anionischer, kationischer, nichtionischer und amphoterer Tenside. Diese oberflächenaktiven Substanzen können einzeln oder im Gemisch enthalten sein.

Besonders bevorzugt sind Tenside, wie beispielsweise Natriumdodecylsulfat und Fettalkoholethoxylate, wie Polyoxyethylenlaurylether, sowie deren Mischungen.

Als Entlüfter und Entschäumer können bevorzugt Octanol, Polydimethylsilan und ähnliche gleich wirkende Substanzen sowie deren Mischungen enthalten sein.

Um die pastöse Konsistenz der erfindungsgemäßen Zusammensetzungen zu erreichen, werden polymere anorganische und organische Verdicker, Gel- und Netzwerkbildner wie Polyacrylsäuren, Polyacrylate, Polyacrylamide, Celluloseether, wie beispielsweise Methylcellulose, Hydroxyethylcellulose (HEC), Hydroxypropylcellulose und Carboxymethylcellulose, Polyvinylpyrrolidon (PVP), Polyvinylacetat, Stärke, (Hetero-)Polysaccharide, wie Pektin, Xanthan, Carubin, Rhoximat, Gummi arabicum, Xanthan Gummi, Agrose und Agar, sowie Gelatine und Bentonit hinzugefügt. Zur Randentschichtung können Ätzpasten verwendet werden, worin die entsprechende Verdicker einzeln oder deren Mischungen enthalten sind.

Als polymere anorganische und organische Füllstoffe können in den Pasten modifizierte und nicht-modifizierte hochdisperse und pyrogene Kieselgele, Flammruß und Graphit, Kunststoffwachse und - granulate, Glaskugeln und Glassplitter, Zeolithe, Aluminiumsilikat, Bentonit und ähnliche sowie deren Mischungen dienen.

Einfache Ausführungsformen der erfindungsgemäßen Ätzpasten bestehen vorzugsweise aus einer Mischung, bestehend aus Lösungsmitteln, einem Oxidationsmittel, einer anorganischen Säure, einem Komplex- oder Chelatbildner, sowie Verdicker und Füllstoffen, wobei jedoch nicht alle oben genannten Komponenten enthalten sein müssen

Wie oben beschrieben, sind die so zusammengesetzten Ätzpasten geeignet, Stapel funktionaler dünner Schichten in einem Schritt zu ätzen, wobei der Schichtenstapel wie folgt aufgebaut sein kann: Trägermaterial/untere Elektrode/gegensätzlich dotierte und undotierte Halbleiterschichten/obere Elektrode.

Gegebenenfalls sind diese Pasten gleichzeitig auch zum Anätzen und Aufrauen des Trägermaterials geeignet. In besonderen Fällen kann das Trägermaterial der unteren Elektrode entsprechen. Gleichzeitig kann in einer besonderen Ausführungsform des zu behandelnden "Solarmoduls" die obere Elektrode gleich der unteren Elektrode sein.

Die untere Elektrode wiederum kann transparent sein und vorzugsweise aus Indium-Zinnoxid (ITO), Indium-Zinkoxid (IZO), Indiumoxid (IO), Aluminium-Zinkoxid (AZO), Zinkoxid (ZO) oder ähnlichen Oxiden bestehen, während die obere Elektrode vorzugsweise aus Al, Ag, Cu, Ni, Cr, Mo, Ta, Ti, V, W sowie Legierungen der genannten Elemente, mit teilweise hier nicht näher spezifizierten weiteren Legierungsbestandteilen, Metalldoppel- und Tripelschichten, wobei wiederum eine Schicht mindestens eines aus der Gruppe der erwähnten Metalle sowie dessen Legierungen beinhaltet, und schließlich oxidischen und mischoxidischen leitfähigen Materialien, wie oben genannt, bestehen kann.

Die dotierten und undotierten Halbleiterschichten des Schichtaufbaus eines "Solarmoduls" bestehen vorzugsweise aus dotiertem und undotiertem a-Si und µ-Si (p-i-n sowie n-i-p), sind jedoch nicht notwendigerweise auf die beiden genannten Materialien beschränkt und können auch dotierte und undotierte Schichten aus kristallinem Silicium umfassen. Entsprechende Schichten können darüber hinaus aus Ge und dessen Legierungen, GaAs und dessen ternären und quaternären Mischungen oder aus III-IV- und II-IV-Halbleitern im Allgemeinen bestehen.

Vorteilhafter Weise sind die erfindungsgemäßen Ätzpasten dazu geeignet, all diese Schichten am Rand eines "Solarmoduls" in einem einzigen Schritt bis auf die Trägerschicht sauber zu entfernen, ohne auf der verbleibenden wirksamen Fläche des "Solarmoduls" störende Verunreinigungen zu hinterlassen.

Zur Durchführung des Ätzverfahrens lassen sich die erfindungsgemäßen Pasten, die auf Basis der oben genannten Inhaltsstoffe der Pasten formuliert sind, mittels Siebdruck, Schablonendruck, Dispensen, Dispense-Jetten oder mittels ähnlicher Applizierverfahren auf das zu ätzende Substrat aufbringen und deponieren.

Mit den erfindungsgemäßen Pasten lassen sich in einfacher Weise Ränder von "Solarmodulen" entschichten. Nach dem zur Randentschichtung durchgeführten Ätzschritt zurückgebliebene Pastenreste können in einfacher Weise mittels eines geeigneten Reinigungsverfahrens, wie beispielsweise durch Abblasen mittels eines Druckluftstrahls, unter Druck stehenden Gasstrahls, Wasserdampfstrahl, mit Wasserdampf oder mit organischen Lösungsmitteln oder deren Mischungen, gesättigter Druckluft- oder einem unter Druck stehenden Gasstrahls, Lösemitteldampfstrahls, kryogenen Aerosols (z. B. CO₂-Schnee in einem CO₂-Gasstrahl), eines fokussierten Strahles aus Wasser, organischen Lösemitteln und Mischungen organischer Lösemittel mit und ohne Wasser, alle enthaltend unten näher spezifizierte Additive, sowie weiterhin durch Passieren einer Reinigungsanlage, mit regiospezifischer Pinsel-, Bürsten- und Schwammreinigung, unter der Anwendung von Wasser, organischen Lösemitteln, deren Mischungen, inklusive und exklusive Wasser, sowie enthaltend weiterer Additive, wie beispielsweise Tenside, Mischungen von Tensiden, Komplex- und Chelatbildner, Schauminhibitoren, funktionelle Salze, und anschließender Feinspülung unter Anwendung o. g. Spülmedien von der Oberfläche entfernt werden.

Es wurde weiterhin gefunden, dass die gemäß der vorliegenden Erfindung zur Randentschichtung einsetzbaren Ätzpasten auch geeignet sind zur Strukturierung der oben beschriebenen dotierten oder nichtdotierten, sowie transparenten oxidischen Schichten oder von Metallschichten in Form von Schichten und Schichtstapeln zwecks der Strukturierung (mikro)-elektronischer, mikroelektromechanischer und photovoltaischer Bauteile.

Vorzugsweise sind die erfindungsgemäßen Ätzpasten zum Strukturieren geeignet von rückseitenkontaktierten kristallinen Solarzellen mit und ohne interdigitierende Kontaktstrukturen, von Solarzellen mit vergrabenen Kontakten, MWT-, EWT-, PERC-, PERL und PERT-Solarzellen, von Waferkanten und zur Kantenisolierung kristalliner Solarzellen, zur einseitigen Ätzung und Politur von Siliciumwafern, zur Trennung und Isolierung von Dünnschicht-Solarzellen aus Dünnschicht-Solarmodulen, zur Kontaktierungslochätzung ("Vias") bei der Herstellung von Dünnschicht-Solarmodulen und -zellen, Strukturierungprozesse während der Herstellung von Anzeige-, Kommunikations- und Leuchtelementen auf Basis der Technologien von Dünnfilmtransistoren (TFT), Flüssigkristallen (LCD), Elektrolumineszenz (EL), organischer lichtemittierender Dioden (OLED) und berührungsempfindlicher kapazitiver und resistiver Sensoren.

### Literatur:

[1] Hans-Günther Wagemann, Heinz Eschrich, Photovoltaik, 1. Aufl., 2007, B. G. Teubner Verlag, Wiesbaden, Germany
[2] A. F. Bogenschütz, Ätzpraxis für Halbleiter, 1. Aufl., 1967, Carl Hanser-Verlag, München, Germany

### Beispiele:

Zum besseren Verständnis und zur Verdeutlichung der Erfindung werden im folgenden Beispiele gegeben, die im Rahmen des Schutzbereichs der vorliegenden Erfindung liegen. Diese Beispiele dienen auch zur Veranschaulichung möglicher Varianten. Aufgrund der allgemeinen Gültigkeit des beschriebenen Erfindungsprinzips sind die Beispiele jedoch nicht geeignet, den Schutzbereich der vorliegenden Anmeldung nur auf diese zu reduzieren.

Die in den Beispielen gegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immerzu insgesamt 100% addieren.

### Beispiel 1:

Aus 50,2 g HNO₃ (33 %), 10,6 g NH₄HF, 4 g Xanthangummi, 10,6 g Isopropanol wird eine Paste hergestellt, indem die Bestandteile nacheinander miteinander durch intensives Rühren vermischt werden.

Die Paste wird auf einem "Solarmodul" aus Glas-AZO-aSi-Al appliziert. Die Ätzung des Schichtenstapels auf einer Heizplatte erfolgt für 3 Minuten bei 100 °C. Nach Austrocknung der Paste bei 120 °C werden die Pastenreste innerhalb von 2 Minuten mittels eines fokussierten Druckluftstrahls abgeblasen. Die anschließende Messung der Leitfähigkeit zwischen zwei Punkten in den geätzten Strukturen ergibt einen Widerstand > 30 MOhm.

### Beispiel 2:

Aus 170 g H₃PO₄ (85 %), 20 ml Wasser, 10 ml HNO₃ (65 %, 20 g Polyvinylpyrrolidon, 3 g Hydroxyethylcellulose, 2,3 g Polyoxyethylenlaurylether, 3 g Polyoxyethylenstearylether, 5,2 g Flammruß wird eine Paste hergestellt, indem die Bestandteile nacheinander miteinander durch intensives Rühren vermischt werden.

Anschließend wird
a) die Paste auf eine Aluminiumschicht auf Glas appliziert und für 2 Minuten bei 60°C geätzt
   und
b) die Paste auf eine Mo/Al-Doppelschicht auf Glas appliziert und für 10 Minuten bei 60 °C geätzt.

Anschließend werden die Pastenreste mittels eines Wasserstrahls abgespült. In beiden Fällen erfolgt die Strukturierung der Metallschichten. Die anschließende Messung der Leitfähigkeit zwischen zwei Punkten in den geätzten Strukturen ergibt einen Widerstand > 30 MOhm.

### Beispiel 3:

Aus 170 g H₃PO₄ (85 %), 20 g NH₄HF₂, 20 ml Wasser, 10 ml HNO₃ (65 %), 20 g Polyvinylpyrrolidon, 3 g Hydroxyethylcellulose, 2,3 g Polyoxyethylenlaurylether oder 3 g Polyoxyethylenstearylether und 5,2 g Flammruß wird eine Paste hergestellt, indem die Bestandteile nacheinander miteinander durch intensives Rühren vermischt werden.

Anschließend wird
a) die Paste auf Aluminiumschichten auf Glas appliziert und für 2 Minuten eine Ätzung bei 60°C durchgeführt
   und
b) die Paste auf einer Mo/AI-Doppelschicht auf Glas appliziert und für 10 Minuten eine Ätzung bei 60°C durchgeführt.

Nach erfolgter Ätzung werden die Pastenreste mittels eines Wasserstrahls abgespült. In beiden Fällen erfolgt eine Strukturierung der Metallschichten. Die anschließende Messung der Leitfähigkeit zwischen zwei Punkten in den geätzten Strukturen ergibt einen Widerstand > 30 MOhm.

### Beispiel 4:

Aus 50 g H₃PO₄ (85 %), 6 g NH₄HF₂, 10 ml HNO₃ (65 %), 5 g Polyvinylpyrrolidon, 1 g Polyoxyethylenlaurylether, 1 g Polyoxyethylenstearyether und 5 g Polyolefingranulat wird eine Paste hergestellt, indem die Bestandteile nacheinander miteinander durch intensives Rühren vermischt werden.

Die Paste wird auf einem "Solarmodul" aus Glas-AZO-aSi-Al appliziert und für 5 Minuten bei 50 °C auf einer Heizplatte eine Ätzung des Schichtenstapels durchgeführt. Nach Austrocknung der Paste bei 120 °C für 2 Minuten werden die Pastenreste abgeblasen mittels eines fokussierten Druckluftstrahls. Die anschließende Messung der Leitfähigkeit zwischen zwei Punkten in den geätzten Strukturen ergibt einen Widerstand > 30 MOhm.

### Beispiel 5:

Aus 50 g H₃PO₄ (85 %), 6 g NH₄HF₂, 10 ml HNO₃ (65 %), 5 g Polyvinylpyrrolidon und 5 g Polyolefingranulat wird eine Paste hergestellt, indem die Bestandteile nacheinander durch intensives Rühren miteinander vermischt werden.

Die Paste wird auf einem "Solarmodul" aus Glas-AZO-aSi-Al appliziert. Das so behandelte "Solarmodul" wird für 5 Minuten auf einer Heizplatte auf eine Temperatur von 50 °C erwärmt und eine Ätzung des Schichtenstapels durchgeführt. Nach Austrocknung der Paste bei 120 °C für 2 Minuten werden die Pastenreste abgeblasen mittels eines fokussierten Druckluftstrahls.

Die anschließende Messung der Leitfähigkeit zwischen zwei Punkten in den geätzten Strukturen ergibt einen Widerstand > 30 MOhm.

### Beispiel 6:

Aus 50 g 85 % H₃PO₄, 6 g NH₄HF₂, 10 ml 65 % HNO₃, 3 g Polyvinylpyrrolidon, 3 g aminofunktionalisierter Polyacrylsäure und 6 g Polyolefingranulat wird eine Paste hergestellt, indem die Bestandteile nacheinander miteinander durch intensives Rühren vermischt werden.

Die Paste wird auf einem "Solarmodul" aus Glas-AZO-aSi-Al appliziert. Das so behandelte "Solarmodul" wird für 5 Minuten auf einer Heizplatte auf eine Temperatur von 50 °C erwärmt und eine Ätzung des Schichtenstapels durchgeführt. Nach Austrocknung der Paste bei 120 °C für 2 Minuten werden die Pastenreste abgeblasen mittels eines fokussierten Druckluftstrahls.

Die anschließende Messung der Leitfähigkeit zwischen zwei Punkten in den geätzten Strukturen ergibt einen Widerstand > 30 MOhm.

## Patentansprüche

1. Verfahren zur nasschemischen Randentschichtung von Dünnschichtsolarzellen, **dadurch gekennzeichnet, dass** auf den Rand der Substratoberfläche eine Ätzpaste, enthaltend 85%-ige H₃PO₄, NH₄HF₂ und 65-%ige HNO₃ in einem Verhältnis in einem Bereich von 7 : 1 : 1,5 bis 10 : 1 : 3,5 bezogen auf das Gewicht, lokal aufgetragen wird und nach erfolgter Reaktion die Pastenreste entfernt werden und gegebenenfalls die Substratoberfläche in geeigneter Weise gereinigt und getrocknet wird.

2. Verfahren gemäß Anspruch 1, **dadurch gekennzeichnet, dass** eine Ätzpaste in einer Breite von etwa einem bis zwei Zentimeter auf den Rand der Substratoberfläche für den Ätzschritt aufgetragen wird.

3. Verfahren gemäß Anspruch 1, **dadurch gekennzeichnet, dass** in einem Ätzschritt Schichten bestehend aus dotierten und undotierten Halbleiterschichten wie Silicium, a-Si-und µ-Si-(p-i-n und n-i-p)-Schichten, Ge und dessen Legierungen, oder aus GaAs und dessen ternären und quaternären Mischungen oder aus III-IV- und II-IV-Halbleitern
und Schichten bestehend aus Metall oder Metall-Legierungen, wie Al, Ag, Cu, Ni, Cr, Mo, Ta, Ti, V, W, Zn, TiₓW_{y}, NiₓV_{y}, TaₓN_{y}, TiₓN_{y}, und/oder Schichten bestehend aus Oxiden oder Mischoxiden, wie Indium-Zinnoxid (ITO), Indium-Zinkoxid (IZO), Indiumoxid (IO), Aluminium-Zinkoxid (AZO), Zinkoxid (ZO) oder ähnlichen Oxiden in einem Schritte geätzt werden.

4. Verfahren gemäß einem oder mehreren der Ansprüche 1 bis 3,
**dadurch gekennzeichnet, dass** das Ätzen bei einer Temperatur im Bereich von 30 bis 100 °C erfolgt.

5. Verfahren gemäß einem oder mehreren der Ansprüche 1 bis 4,
**dadurch gekennzeichnet, dass** im Anschluss an den Ätzschritt die Pastenreste durch Waschen oder Abblasen und Austrocknung bei erhöhter Temperatur im Bereich von 100 bis 150°C entfernt werden.

6. Pastenzusammensetzung, enthaltend 85%-ige H₃PO₄, NH₄HF₂ und 65-%ige HNO₃ in einem Verhältnis in einem Bereich von 7 : 1 : 1,5 bis 10 : 1 : 3,5 bezogen auf das Gewicht.

7. Zusammensetzung gemäß Anspruch 6, enthaltend 85%-ige H₃PO₄, NH₄HF₂ und 65-%ige HNO₃ in einem Verhältnis in einem Bereich von 7,5 : 1 : 1,8 bis 9 : 1 : 3 bezogen auf das Gewicht.

8. Zusammensetzung gemäß Anspruch 6 oder Anspruch 7, enthaltend Polyvinylpyrrolidon und Polyolefingranulat als Verdickungsmittel.

9. Zusammensetzung gemäß einem oder mehreren der Ansprüche 6 bis 8, enthaltend Polyvinylpyrrolidon, Polyolefingranulat und aminofunktionalisierter Polyacrylsäure.

10. Verwendung einer Pastenzusammensetzung gemäß einem oder mehreren der Ansprüche 6 bis 8 zum Randentschichten von Dünnschichtsolarzellen.

11. Verwendung einer Pastenzusammensetzung gemäß einem oder mehreren der Ansprüche 6 bis 8 zum Ätzen von Stapeln funktionaler dünner Schichten von Dünnschichtsolarzellen in einem Schritt, wobei die Schichten aus dotierten und undotierten Halbleiterschichten wie Silicium, a-Si- und µ-Si-(p-i-n und n-i-p)-Schichten, Ge und dessen Legierungen, oder aus GaAs und dessen ternären und quaternären Mischungen oder aus II-IV- und 11-VI-Halbleitern bestehen und aus Schichten aus Metall oder Metall-Legierungen, wie Al, Ag, Cu, Ni, Cr, Mo, Ta, Ti, V, W, Zn, TiₓW_{y}, NiₓV_{y}, TaₓN_{y}, TiₓN_{y}, und/oder Schichten bestehend aus Oxiden oder Mischoxiden, wie Indium-Zinnoxid (ITO), Indium-Zinkoxid (IZO), Indiumoxid (IO), Aluminium-Zinkoxid (AZO), Zinkoxid (ZO) oder ähnlichen Oxiden.

## Claims

1. Method for the wet-chemical edge deletion of thin-film solar cells, **characterised in that** an etching paste comprising 85% H₃PO₄, NH₄HF₂ and 65% HNO₃ in a ratio in the range from 7 : 1 : 1.5 to 10 : 1 : 3.5, based on the weight, is applied locally to the edge of the substrate surface, and, when the reaction is complete, the paste residues are removed and the substrate surface is optionally cleaned and dried in a suitable manner.

2. Method according to Claim 1, **characterised in that** an etching paste is applied to the edge of the substrate surface in a width of about one to two centimetres for the etching step.

3. Method according to Claim 1, **characterised in that** layers consisting of doped and undoped semiconductor layers, such as silicon, a-Si and µ-Si (p-i-n and n-i-p) layers, Ge and alloys thereof, or of GaAs and ternary and quaternary mixtures thereof, or of III-IV and II-IV semiconductors and layers consisting of metal or metal alloys, such as Al, Ag, Cu, Ni, Cr, Mo, Ta, Ti, V, W, Zn, TiₓW_{y}, NiₓV_{y}, TaₓN_{y}, TiₓN_{y}, and/or layers consisting of oxides or mixed oxides, such as indium tin oxide (ITO), indium zinc oxide (IZO), indium oxide (IO), aluminium zinc oxide (AZO), zinc oxide (ZO) or similar oxides, are etched in one step.

4. Method according to one or more of Claims 1 to 3, **characterised in that** the etching is carried out at a temperature in the range from 30 to 100°C.

5. Method according to one or more of Claims 1 to 4, **characterised in that** the paste residues are removed after the etching step by washing or blowing off and drying out at an elevated temperature in the range from 100 to 150°C.

6. Paste composition comprising 85% H₃PO₄, NH₄HF₂ and 65% HNO₃ in a ratio in the range from 7 : 1 : 1.5 to 10 : 1 : 3.5, based on the weight.

7. Composition according to Claim 6, comprising 85% H₃PO₄, NH₄HF₂ and 65% HNO₃ in a ratio in the range from 7.5 : 1 : 1.8 to 9 : 1 : 3, based on the weight.

8. Composition according to Claim 6 or Claim 7, comprising polyvinylpyrrolidone and polyolefin granules as thickener.

9. Composition according to one or more of Claims 6 to 8, comprising polyvinylpyrrolidone, polyolefin granules and amino-functionalised polyacrylic acid.

10. Use of a paste composition according to one or more of Claims 6 to 8 for the edge deletion of thin-film solar cells.

11. Use of a paste composition according to one or more of Claims 6 to 8 for the etching of stacks of functional thin layers of thin-film solar cells in one step, where the layers consist of doped and undoped semiconductor layers, such as silicon, a-Si and µ-Si (p-i-n and n-i-p) layers, Ge and alloys thereof, or of GaAs and ternary and quaternary mixtures thereof, or of II-IV and II-VI semiconductors,
and layers consisting of metal or metal alloys, such as Al, Ag, Cu, Ni, Cr, Mo, Ta, Ti, V, W, Zn, TiₓW_{y}, NiₓV_{y}, TaₓN_{y}, TiₓN_{y},
and/or layers consisting of oxides or mixed oxides, such as indium tin oxide (ITO), indium zinc oxide (IZO), indium oxide (IO), aluminium zinc oxide (AZO), zinc oxide (ZO) or similar oxides.

## Revendications

1. Procédé pour la délétion chimique par voie humide de bords de cellules solaires à film mince, **caractérisé en ce qu'**une pâte de gravure comprenant du H₃PO₄ à 85%, du NH₄HF₂ et du HNO₃ à 65% selon un rapport dans la plage de 7 : 1 : 1,5 à 10 : 1 : 3,5, sur la base du poids, est appliquée localement sur le bord de la surface de substrat et, lorsque la réaction est terminée, les résidus de pâte sont enlevés et la surface de substrat est en option nettoyée et séchée d'une façon appropriée.

2. Procédé selon la revendication 1, **caractérisé en ce qu'**une pâte de gravure est appliquée sur le bord de la surface de substrat sur une largeur d'environ un à deux centimètre(s) pendant l'étape de gravure.

3. Procédé selon la revendication 1, **caractérisé en ce que** des couches constituées par des couches semiconductrices dopées et non dopées, telles que des couches en silicium, des couches en a-Si et en µ-Si (p-i-n et n-i-p), en Ge et en alliages afférents, ou en GaAs et en des mélanges ternaires et quaternaires afférents, ou en semiconducteurs III-IV et II-IV et des couches constituées par des métaux ou des alliages de métaux, tels que Al, Ag, Cu, Ni, Cr, Mo, Ta, Ti, V, W, Zn, TiₓW_{y}, NiₓV_{y}, TaₓN_{y}, TiₓN_{y}, et/ou **en ce que** des couches constituées par des oxydes ou des oxydes mixtes, tels que de l'oxyde d'indium et d'étain (ITO), de l'oxyde d'indium et de zinc (IZO), de l'oxyde d'indium (IO), de l'oxyde d'aluminium et de zinc (AZO), de l'oxyde de zinc (ZO) ou des oxydes similaires, sont gravées en une seule étape.

4. Procédé selon une ou plusieurs des revendications 1 à 3, **caractérisé en ce que** la gravure est mise en oeuvre à une température dans la plage de 30 à 100°C.

5. Procédé selon une ou plusieurs des revendications 1 à 4, **caractérisé en ce que** les résidus de pâte sont enlevés après l'étape de gravure par lavage ou par soufflage et séchage à une température élevée dans la plage de 100 à 150°C.

6. Composition de pâte comprenant du H₃PO₄ à 85%, du NH₄HF₂ et du HNO₃ à 65% selon un rapport dans la plage de 7 : 1 : 1,5 à 10 : 1 : 3,5, sur la base du poids.

7. Composition selon la revendication 6, comprenant du H₃PO₄ à 85%, du NH₄HF₂ et du HNO₃ à 65% selon un rapport dans la plage de 7,5 : 1 : 1,8 à 9 : 1 : 3, sur la base du poids.

8. Composition selon la revendication 6 ou la revendication 7, comprenant des granules de polyvinylpyrrolidone et de polyoléfine en tant qu'épaississeur.

9. Composition selon une ou plusieurs des revendications 6 à 8, comprenant des granules de polyvinylpyrrolidone, de polyoléfine et de l'acide polyacrylique amino-fonctionnalisé.

10. Utilisation d'une composition de pâte selon une ou plusieurs des revendications 6 à 8 pour la délétion de bords de cellules solaires à film mince.

11. Utilisation d'une composition de pâte selon une ou plusieurs des revendications 6 à 8 pour la gravure de piles de couches minces fonctionnelles de cellules solaires à film mince en une seule étape, où les couches sont constituées par des couches semiconductrices dopées et non dopées, telles que des couches en silicium, des couches en a-Si et en µ-Si (p-i-n et n-i-p), en Ge et en alliages afférents, ou en GaAs et en des mélanges ternaires et quaternaires afférents, ou en semiconducteurs II-IV et II-VI,
et des couches constituées par des métaux ou des alliages de métaux, tels que Al, Ag, Cu, Ni, Cr, Mo, Ta, Ti, V, W, Zn, TiₓW_{y}, NiₓV_{y}, TaₓN_{y}, TiₓN_{y},
et/ou des couches constituées par des oxydes ou des oxydes mixtes, tels que de l'oxyde d'indium et d'étain (ITO), de l'oxyde d'indium et de zinc (IZO), de l'oxyde d'indium (IO), de l'oxyde d'aluminium et de zinc (AZO), de l'oxyde de zinc (ZO) ou des oxydes similaires.
